# EUROPÄISCHE PATENTSCHRIFT

(11) **EP 0 905 794 B1**
(45) Veröffentlichungstag und Bekanntmachung des Hinweises auf die Patenterteilung: **29.12.2004**
(21) Anmeldenummer: 98117981.5
(22) Anmeldetag: 23.09.1998
(51) Int. Cl.: H01L 31/0224, H01L 31/18, H01L 31/0352, H01L 31/0236

(54) **Solarzelle und Herstellungsverfahren**
Solar cell and method of fabrication
Cellule solaire et procédé de fabrication

(30) Priorität: 23.09.1997 DE 19741832
(43) Veröffentlichungstag der Anmeldung: 31.03.1999
(73) Patentinhaber: Institut für Solarenergieforschung GmbH, 31860 Emmerthal (DE)
(72) Erfinder: Hezel, Rudolf, 31789 Hameln (DE); Metz, Axel, 31785 Hameln (DE)
(74) Vertreter: Stoffregen, Hans-Herbert, Dr. Dipl.-Phys.

(56) Entgegenhaltungen:
- EP-A- 0 561 615
- US-A- 4 379 944
- VERBEEK, M. ET AL.: "Mechanically grooved high-efficinecy silicon solar cells with self-aligned metallisation" CONFERENCE RECORD OF THE TWENTY FIFTH IEEE PHOTOVOLTAIC SPECIALISTS CONFERENCE - 1996, 13. - 17. Mai 1996, Seiten 521-524, XP002121004 Washington, DC
- HEZEL, R.: "A novel approach to cost-effective high-efficiency solar cells" 13TH EUROPEAN PHOTOVOLTAIC SOLAR ENERGY CONFERENCE PROCEEDINGS, 23. - 27. Oktober 1995, Seiten 115-118, XP002121005 Nice, France
- HEZEL R ET AL: "A new strategy for the fabrication of cost-effective silicon solar cells" RENEWABLE ENERGY, Bd. 14, Nr. 1-4, 8. Mai 1998 (1998-05-08), Seite 83-88 XP004126823 ISSN: 0960-1481

## Beschreibung

Die Erfindung bezieht sich auf eine Solarzelle umfassend ein Halbleitermaterial für ein Halbleitersubstrat, in welchem durch einfallende Strahlungsenergie Ladungsträger erzeugbar sind, die durch ein elektrisches Feld trennbar und sodann über auf dem Halbleitersubstrat vorhandene erste und zweite elektrisch leitende Kontakte ableitbar sind, wobei auf einer ersten Halbleitersubstratoberfläche rinnenförmige Vertiefungen mit jeweils zumindest einem senkrecht oder nahezu senkrecht zur von der ersten Halbleiteroberfläche aufgespannten Ebene verlaufend flankenartigen Bereich vorhanden sind und wobei auf einem oder mehreren der flankenartigen Bereiche elektrisch leitfähiges Material zur Ausbildung des ersten elektrisch leitenden Kontaktes aufgebracht ist, der sich ausschließlich auf dem entsprechenden flankenartigen Bereich erstreckt. Ferner nimmt die Erfindung Bezug auf ein Verfahren zur Herstellung einer Solarzelle umfassend ein Halbleitermaterial für ein Halbleitersubstrat, in welchem durch einfallende Strahlungsenergie Ladungsträger erzeugbar sind, die durch ein elektrisches Feld trennbar und sodann über auf dem Halbleitersubstrat vorhandene erste und zweite elektrisch leitende Kontakte ableitbar sind, wobei auf einer ersten Halbleitersubstratoberfläche rinnenförmige Vertiefungen mit ersten flankenartigen Bereichen ausgebildet werden, auf denen ausschließlich elektrisch leitfähiges Material zur Ausbildung der ersten elektrisch leitenden Kontakte aufgebracht wird.

Zur industriellen Herstellung der Metallkontakte konventioneller kristalliner Siliziumsolarzellen ist das Verfahren der Metallisierung mittels Siebdruck am weitesten verbreitet. Hierbei wird eine metallhaltige Paste durch ein schablonenartig ausgebildetes Sieb gepreßt und so auf die Solarzellenoberflächen an den gewünschten Stellen aufgebracht. Anschließend werden die Pasten bei erhöhter Temperatur (ca. 700° C - 800° C) gesintert, um die in den Pasten vorhandenen Lösungsmittel auszutreiben sowie einen möglichst elektrisch gut leitfähigen und mechanisch stabilen Kontakt zur Siliziumoberfläche herzustellen. Der hauptsächliche Vorteil dieses Verfahrens liegt in dessen. Einfachheit und den sich daraus ergebenden niedrigen Produktionskosten. Jedoch weist dieses Verfahren auch zahlreiche Nachteile auf. Siebgedruckte Kontaktlinien weisen fertigungsbedingt typischerweise eine Breite von mehr als 100 µm auf. Daraus resultiert eine relativ großflächige Abschattung der lichtempfindlichen Solarzellenoberfläche, die bei ca. 12% liegt. Ferner erfordert der hohe Anteil abgeschatteter Oberfläche einen Fingerabstand von mindestens 3 mm. Dies erfordert wiederum eine starke Emitterdiffusion, um die Widerstandsverluste in der diffundierten Schicht in einem verträglichen Rahmen zu halten. Ein weiteres problematisches Gebiet der Solarzellen mit Siebdruckkontakten ist der hohe Kontaktwiderstand des Metall-Halbleiter-Kontaktes. So ist es nötig, zur Erzielung genügend kleiner Übergangswiderstände vom Halbleiter in das Metallgitter eine hohe Oberflächenkonzentration, von Dotieratomen zu gewährleisten. Diese Anforderungen der starken Emitterdiffusion und der hohen Oberflächenkonzentration führen jedoch zu einer schlechten Empfindlichkeit im Bereich der kurzwelligen Strahlung des Sonnenlichts. Dies kann dadurch erklärt werden, daß die kurzwellige Strahlung sehr nahe unter der Solarzellenoberfläche absorbiert wird und dort Elektronen-Loch-Paare erzeugt, die aufgrund der hohen Dotierung mit Fremdatomen in diesem Bereich sehr schnell rekombinieren, ohne zum lichterzeugten Strom der Solarzelle beizutragen.

Ein Ansatz, die oben genannten Probleme der Siebdruck-Solarzellen zu verringern, stellt die sogenannte "Buried Contact"-Solarzelle (BCSC) dar (US-PAT 4726850). Bei diesem Zelltyp werden auf der Oberfläche schmale und tiefe Gräben (Breite: Tiefe 1:2-1:7) erzeugt, die den Ort und die Form der Metallisierung vorgeben. Diese wird nach Erzeugung der Gräben mit Hilfe des Verfahrens der stromlosen Galvanik aufgebracht. Dabei füllt das abgeschiedene Metall die Gräben vollständig oder nahezu vollständig aus. Durch die Erzeugung sehr schmaler Gräben (20-50 µm) konnten die Abschattungsverluste gegenüber Siebdruckzellen zwar reduziert werden, doch weist auch dieses Verfahren der Solarzellenherstellung zahlreiche Nachteile auf. Um das scheinbar einfache Verfahren der stromlosen Galvanik zur Metallisierung dieser Solarzellen anwenden zu können, sind eine Reihe zusätzlicher und energieaufwendiger Prozeßschritte notwendig. Neben dem erforderlichen Hochtemperaturschritt zur Eminerdiffusion (bei ca. 850°C) werden zur Herstellung der konventionellen BCSC noch mindestens zwei weitere zeit- und energieaufwendige Hochtemperaturschritte (jeweils mehrere Stunden bei ca. 1000°C ) benötigt (C. B. Honsberg et al., Conf. Rec. 24th IEEE Photovoltaic Specialists Conference, Hawaii, 1994, S. 1473-1476). Der erste dieser beiden zusätzlichen Hochtemperaturschritte dient der Herstellung einer Diffusionsbarriere, bestehend aus einem dicken thermischen Oxid für die anschließende Tiefdiffusion in den Gräben. Der zweite ist die Tiefdiffusion in den Gräben selbst. Sie dient im wesentlichen der Verringerung korrosionsbedingter Kurzschlüsse im Bereich der galvanisch abgeschiedenen Metallfinger, die üblicherweise aus Nickel, Kupfer und Silber bestehen. Auch ist dieser Metallisierungsschritt verbunden mit großen Mengen an Galvanikbädern und -abfällen, die als ökologisch bedenklich gelten. Ferner führt diese Art der Metallisierung, bei der die Form und Ausdehnung der Kontakte ausschließlich durch die der Gräben bestimmt werden, zu einer relativ großen Metall-Halbleiter Kontaktfläche, was eine Reduktion der Leerlaufspannung und damit des Wirkungsgrades zur Folge hat.

Es ist allgemein bekannt, daß vakuumaufgedampfte Kontakte die besten Kontakteigenschaften aufweisen im Vergleich zu den vorgenannten siebgedruckten bzw. galvanisch abgeschiedenen Kontakten. Als vielversprechende Möglichkeit zur Herstellung von Metallkontakten auf Solarzellen ist das Verfahren der Vakuumaufdampfung unter einem kleinen Winkel zur Solarzellenoberfläche bekannt (Borden et al. Proc. 16th IEEE Photovoltaic Specialists Conference, San Diego, 1982, S. 574 ff, und Hezel Proc. 13th European Photovoltaik Solar Energy Conference, Nice, 1995, S. 115-118). Hierbei wird die Solarzellenoberfläche mit eng aneinanderliegenden parallel verlaufenden Gräben versehen, die üblicherweise halbkreis- oder V-förmig ausgebildet sind. Die so geschaffenen sehr schmalen Erhöhungen dienen somit als Schattenwurfkanten bei der nachfolgenden Aufdampfung des metallischen Kontaktmaterials unter einem flachen Winkel zur Substratoberfläche. Durch dieses Verfahren des Schrägaufdampfens werden die üblichen Nachteile des konventionellen senkrecht Aufdampfens durch eine Schattenmaske vermieden, da durch die Ausgestaltung der selbstabschattenden Erhöhungen zum einen auf die Verwendung einer Schattenmaske zur Definition des Kontaktgitters verzichtet werden kann und zum anderen der Anlagendurchsatz gegenüber einer senkrecht erfolgenden Aufdampfung erheblich erhöht werden kann, da die Solarzellen in einem sehr flachen Winkel zur Aufdampfrichtung sehr dicht angeordnet werden (Hezel Proc. 13th European Photovoltaik Solar Energy Conference, Nice, 1995, S. 115). Auch wird hierbei das Aufdampfmaterial viel besser ausgenutzt als bei der senkrechten Aufdampfung, bei der sich der größte Teil des Metalls auf den Masken niederschlägt und von diesen erst wieder arbeitsintensiv abgeätzt werden muß. Das hier vorgestellte Verfahren erlaubt eine Variation der Fingerbreite im wesentlichen durch eine Variation des Aufdampfwinkels, da die Grabenbreite meist durch das verwendete Werkzeug (z. B. diamantbesetztes Sägeblart, Draht mit Läppmittel) vorgegeben ist. Auch ist der Abstand der einzelnen Kontaktfinger bei diesen Strukturen unmittelbar durch die Werkzeugbreite vorgegeben. Zellen dieses Typs erreichen gegenwärtig Wirkungsgrade von 18.6% (Verbeek et al., Proc. 25th IEEE Photovoltaik Specialists Conference, Washington D.C., 1996, S. 521). Durch die vom Druck in der Aufdampfkammer, der Ausdehnung der Aufdampfquelle und der Streuung des Materials an den Schattenwurfkanten abhängige Divergenz des Aufdampfstrahls ist ein scharfer Schattenwurf der Erhöhungen lediglich bis zu einem Abstand von ca. 500 µm erzielbar. Der maximale Fingerabstand dieses Zelltyps ist damit auf weniger als 500 µm beschränkt. Auch tritt bei V-förmigen Gräben eine relativ hohe Verschattung durch die Metallfinger auf, da diese auf Ebenen verlaufen, die üblicherweise einen Winkel von ca. 35° zur Substratnormalen aufwiesen. Ferner ist bei den oben genannten Strukturen der erforderliche Siliziumabtrag recht hoch, da die Rinnen dicht beieinander verlaufen. Dies führt zu einer erhöhten Abnutzung der zur Strukturierung verwendeten Werkzeuge sowie zu erhöhten Bearbeitungskosten.

Aus der EP 0 561 615 A2 ist eine Verschaltung von separaten IR-Detektoren zu einer vorteilhaften dichten und kompakten Anordnung zu entnehmen. Dabei können zum Verschalten einzelner Bauelemente elektrische Kontakte vertikal zur Oberfläche der Bauelemente verlaufen, eine Maßnahme, wie diese aus dem Verschalten von einzelnen Solarzellen zu Solarzellenmodulen bekannt ist. Dabei ist es nicht erforderlich, dass der zum Verbinden der Bauelemente erforderliche elektrisch leitende Kontakt über die gesamte Länge entsprechender Flächen von Bauelementen verläuft.

In der US 4,379,944 wird eine Solarzelle mit oberflächenseitig verlaufenden V-förmigen Gräben beschrieben. Dabei ist auf einer Flanke der Gräben ein elektrisch leitendes Material zur Ausbildung eines ersten elektrisch leitenden Kontaktes aufgebracht. Um eine optimale Nutzung bei minimaler Abschattung der Solarzelle durch die elektrisch leitenden Kontakte zu erzielen, wird die Solarzelle auf die einfallende Strahlung ausgerichtet. Der Abstand der V-förmigen Gräben ist durch die Substratorientierung und -dicke in sehr engen Grenzen vorgegeben, wobei der Abstand maximal das 2,7-fache der Grabentiefe betragen darf.

Der vorliegenden Erfindung liegt das Problem zugrunde, eine Solarzelle sowie ein Verfahren zur Herstellung einer solchen der zuvor beschriebenen Art so weiterzubilden, dass mittels einfacher Technologie und gegebenenfalls unter Anwendung großflächiger und insbesondere sehr einfacher und kostengünstiger Bearbeitungsmethoden Solarzellen sehr effizient herstellbar sind. Dabei soll eine Anwendbarkeit für alle Arten von Halbleitern, Element- und Verbindungshalbleitern, sowohl in einkristalliner Form beliebiger Oberflächenorientierung, in polikristalliner Form jeglicher Korngröße und Orientierung als auch im amorphen Zustand, in selbsttragender (dicker) Ausführung als auch mit Dünnfilmhalbleitern auf Fremdsubstrat möglich sein. Ferner soll eine hohe Variabilität in Bezug auf die Ausbildung der die elektrischen Ladungsträger ableitenden elektrisch leitenden Kontakte möglich sein. Eine Abhängigkeit von einer Kristallorientierung soll nicht gegeben sein. Unabhängig davon soll eine minimale Abschattung des Halbleitersubstratmaterials möglich sein. Auch soil zusätzlich die Möglichkeit geschaffen sein, einfallende Strahlungen optimal einzufangen.

Erfindungsgemäß wird das Problem durch eine Solarzelle der eingangs beschriebenen Art dadurch gelöst, dass zwischen aufeinanderfolgenden Vertiefungen ein in oder in etwa der von der Halbleiteroberfläche aufgespannten Ebene verlaufender plateauartiger Bereich und/oder eine parallel oder in etwa parallel zu der von der Halbleiteroberfläche aufgespannten Ebene verlaufende bodenseitige Fläche verläuft.

Abweichend vom gattungsbildenden Stand der Technik in Form der US 4,379,944 verlaufen zwischen den rinnenförmigen Vertiefungen plateauartige Bereiche bzw. Bodenabschnitte entlang der Ebene, die von der ersten Halbleiteroberfläche aufgespannt ist. Hierdurch ergibt sich der Vorteil, dass der Abstand der ersten elektrisch leitenden Kontakte relativ groß gewählt werden kann, wodurch die Anzahl der Finger, die zu einer Abschattung führen, verringert und damit der Kurzschlussstrom der Zelle erhöht wird.

Ein Verfahren zur Herstellung einer Solarzelle der eingangs genannten Art zeichnet sich dadurch aus, dass die flankenarligen Bereiche derart ausgebildet werden, dass diese senkrecht oder nahezu senkrecht zur von der ersten Halbleitersubstratoberfläche aufgespannten Ebene verlaufen, dass das elektrisch leitende Material zur Ausbildung der ersten elektrisch- leitenden Kontakte maskierungsfrei und selektiv von den Bereichen der Halbleiteroberfläche durch Ätzen abgetragen wird, die außerhalb des flankenartigen Bereichs verlaufen. Weiterbildungen ergeben sich aus den Unteransprüchen.

Dabei wird vorzugsweise das die elektrisch leitenden Kontakte bildende Material ohne Verwendung einer gesonderten Maske auf die flankenartigen Bereiche mit dem Verfahren des Vakuumaufdampfens unter einem flachen Winkel zur Substratebene aufgebracht.

Durch die erfindungsgemäße Lehre können ohne aufwendige Maskentechniken und vorwiegend durch Selbstjustierung zusammenhängende Kontaktfingersysteme mit sehr kleiner Verschattung der lichtempfindlichen Solarzellenoberfläche und dennoch großem Leiterbahnquerschnitt erzeugt werden. Dies ist möglich, da die elektrisch leitenden Kontakte nach dem erfindungsgemäßen Verfaben ausschließlich auf parallel zur Substratnormalen angeordneten flankenartigen Bereichen verlaufen.

Ein weiteres wesentliches Merkmal des Erfindungsgedankens ist es, die zum Schrägaufdampfen erforderliche Oberflächenstruktur so auszubilden, daß zum einen die Abschattung durch die Metallfinger bei genügend großem Leiterbahnquerschnitt so gering wie möglich ausfällt, zum anderen der zur Strukturerzeugung notwendige Materialabtrag minimiert wird. Dies führt u.a zu den in den Zeichnungen und Ausführungsbeispielen beschriebenen vorzugsweisen Strukturen.

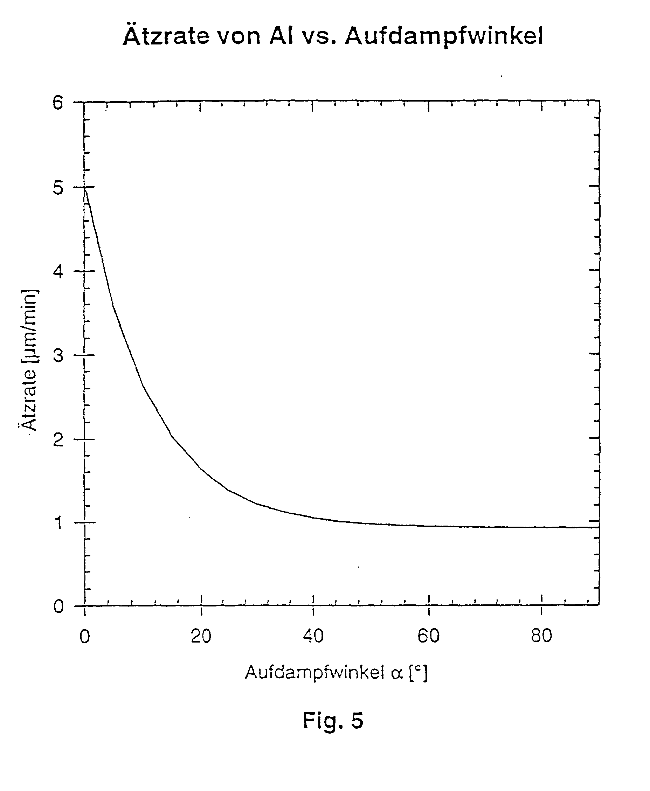

Ein Grundgedanke der vorliegenden Erfindung besieht darin, das besondere Stengelwachstum schrägaufgedampfter Metallschichten erfindungsgemäß vorteilhaft auszunutzen. Dabei wird durch das zunehmende Stengelwachstum bei flacherem Aufdampfwinkel die abgeschiedene Schicht immer poröser. Aus der zunehmenden Porösität der Schichten resultiert, wie in Fig. 5 gezeigt, eine drastische Zunahme der Ätzrate unter ansonsten gleichen äußeren Bedingungen. Die Ausnutzung dieses Effektes ermöglicht es, die oben genannten erfindungsgemäß ausgebildeten Oberflächenstrukturen besonders vorteilhaft zu nutzen, da die auf die nicht flankenartigen Bereiche abgeschiedene Metallschicht sehr leicht abzuätzen ist. Daber muß die Dicke des eigentlichen Metallkontaktes nicht größer ausgelegt werden, um den durch das anschließende Abätzen entstehenden Dickenverlust auszugleichen.

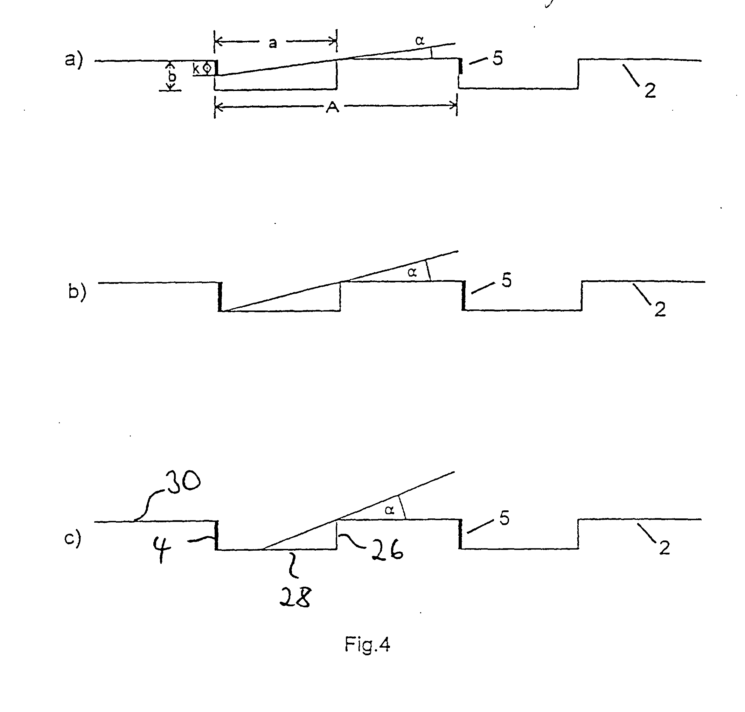

Durch Anwendung der erfindungsgemäßen Lehre ist es ferner - abweichend von dem eingangs diskutierten Stand der Technik - möglich, die Fingerbreiten nicht ausschließlich durch den Aufdampfwinkel α oder die Werkzeugbreite a festzulegen, sondern vollkommen unabhängig von diesen Größen durch die Sägetiefe bzw. Flankenbreite b , vorausgesetzt, daß der Tangens des Aufdampfwinkels α stets größer ist als das Verhältnis von Flankenbreite b zu Abstand Schattenkante/Flanke a (siehe Fig. 4a-c). Diese Tatsache ermöglicht bei der Herstellung die genaue Einstellung des Aufdampfwinkels erheblich unkritischer handzuhaben. Es stellt sich stets die gleiche Kontaktbreite k ein gegeben durch die Flankenbreite b.

Ein sehr wichtiges Merkmal des Erfindungsgedankens ist es, möglichst allgemein anwendbare Oberflächenstrukturen zu schaffen, die es - abweichend von dem eingangs diskutierten Stand der Technik- ermöglichen, auch beliebig große Fingerabstände zu realisieren, was für gewisse Solarzellentypen von entscheidendem Vorteil ist, da durch eine verringerte Fingeranzahl zum einen die Abschattung verringert und damit der Kurzschlußstrom der Zelle erhöht wird, zum anderen aber auch die Metall-Halbleiterkontaktfläche verringert werden kann, was wiederum den positiven Effekt einer Zunahme der Leerlaufspannung aufgrund verringerter Rekombination an den Metallkontakten zur Folge hat.

Auch ist es gegenüber der BCSC von Vorteil, daß die Anforderungen an die Werkzeugbreite und Verschleiß weitaus geringer sind, da nicht wie bei der BCSC möglichst schmale und tiefe Gräben (mit vorzugsweisen Verhältnis, Breite: Tiefe 1:2-1:7) erforderlich sind, sondern relativ breite und flache (mit vorzugsweisem Verhältnis Breite: Tiefe 1:1-10:1). Durch die Ausgestaltung flacher Gräben ist es im Gegensatz zum Stand der Technik auch möglich, sehr dünne Substrate mit einer erfindungsgemäß vorteilhaften Oberflächenstruktur zu versehen. Auch wird erfindungsgemäß die Abschattung durch die Metallkontakte nicht durch die technisch realisierbare Grabenbreite nach unten beschränkt, sondern ist durch die Aufdampfdicke frei wählbar. Dies ist besonders vorteilhaft für Solarzellen mit geringem Fingerabstand wie z. B. dem Typ der MIS-Solarzeile.

Erfindungsgemäß ist auch vorgesehen - abweichend vom eingangs diskutierten Stand der Technik - die Solarzellenoberfläche mit einer zweiten viel kleineren Struktur z. B. Rinnen, Gräben oder Pyramiden zu versehen, um so den Lichteinfang der Solarzellen noch zu verbessern. Somit können beide Parameter (Lichteinfang, Kontaktabstand) unabhängig voneinander optimal ausgelegt werden. Bei den bisher bekannten zum Schrägaufdampfen verwendeten Oberflächenstrukturen diente die zur Kontaktherstellung verwendete Struktur auch immer der Verbesserung des Lichteinfangs. Da die für den optimalen Lichteinfang erforderlichen Strukturen in ihren Ausmaßen prinzipiell um mehr als eine Größenordnung unter denen der Kontaktabstände liegen, wirken sich die beiden in einem kombinierenden Strukturen sehr nachteilig auf den Wirkungsgrad aus. Dieser Nachteil kann durch die erfindungsgemäße Ausbildung der Oberflächenstruktur zur Herstellung der elektrisch leitenden Kontakte eliminiert werden, da sich auf diesen Strukturen besonders einfach und vor allem auch weitestgehend unabhängig von der erfindungsgemäßen Ausbildung dieser Strukturen beliebige den Lichteinfang verbessernde Unterstrukturen anordnen lassen.

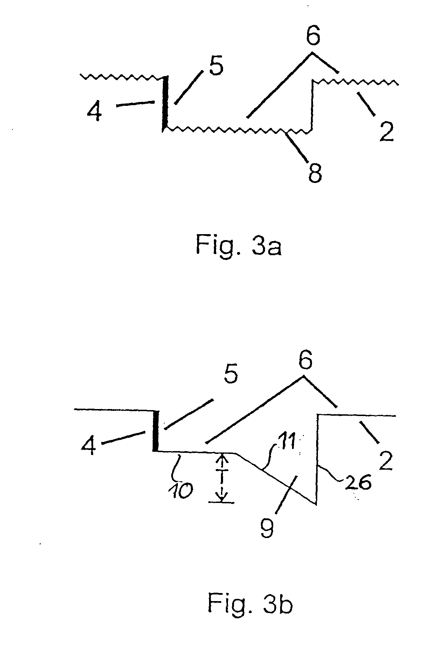

Ein weiterer Erfindungsgedanke besteht darin, vorzugsweise im tiefer liegenden Gebiet zwischen zwei elektrisch leitfähigen Kontakten zusätzlich eine oder mehrere Vertiefungen auszubilden, die auf Grund ihrer Tiefe und des dort weit in das Halbleitervolumen reichenden pn-Übergangs die Sammlung von Minoritätsladungsträgern im Volumen des Halbleiters verbessern. Die Vertiefungen können prinzipiell beliebig geometrisch beschaffen sein. Durch geeignete Formgebung (siehe Fig. 3b) kann jedoch auch der Lichteinfang erhöht werden. Vorzugsweise werden diese Vertiefungen durch geeignete Ausgestaltung des Werkzeugs gleichzeitig mit den Kontaktvertiefungen hergestellt.

Weitere Einzelheiten, Vorteile und Merkmale der Erfindung ergeben sich nicht nur aus den Ansprüchen , den diesen zu entnehmenden Merkmalen - für sich und/oder in Kombination -, sondern auch aus der nachfolgenden Beschreibung eines den Zeichnungen zu entnehmenden bevorzugten Ausführungsbeispiels.

Es zeigen:

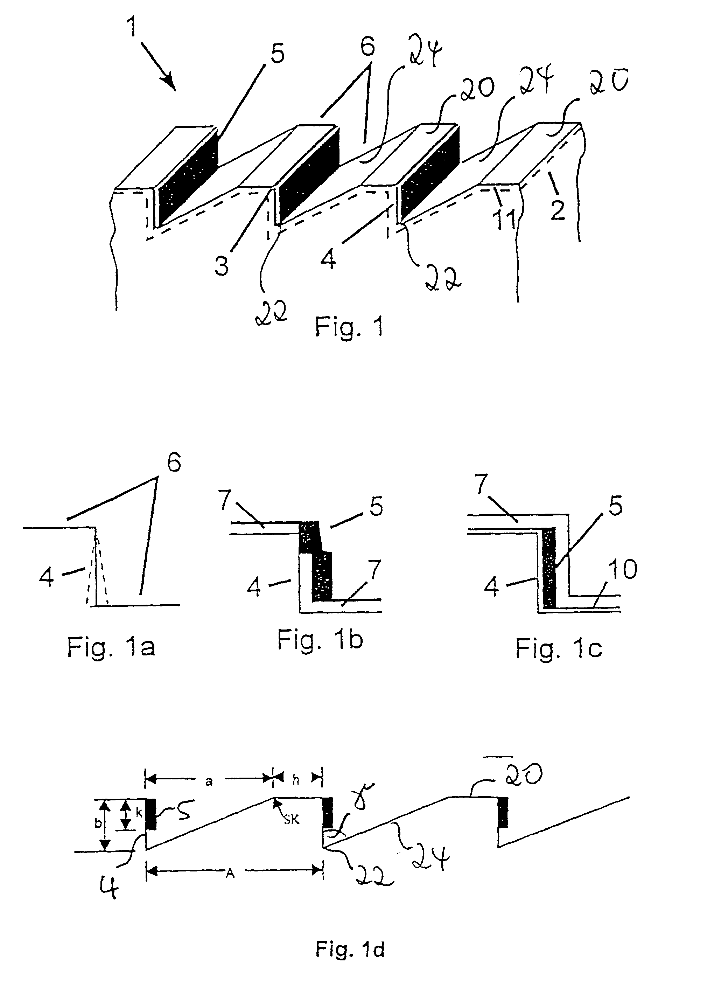

- Fig. 1: Kontaktanordnung auf einer strukturierten Solarzellenoberfläche
- Fig. 1 a: Detail aus Fig. 1 mit drei Ausgestaltungsmöglichkeiten der flankenartigen Bereiche
- Fig. 1 b: Detail aus Fig. 1 mit teilweise passivierter Flanke
- Fig. 1 c: Detail aus Fig. 1 mit Metall-Isolator-Halbleiterkontakt
- Fig. 1 d: die Kontaktanordnung nach Fig. 1 mit Erläuterungen
- Fig. 2: Erfindungsgemäße Ausgestaltungmöglichkeiten der Oberflächenstrucktur der Solarzellen
- Fig. 3a: Oberflächenstruktur mit aufgeprägter zweiter Struktur zur besseren Lichteinkopplung in die Solarzelle
- Fig. 3b: Oberflächenstruktur mit zweiter Struktur zur besseren Sammlung der Minoritätsladungsträger in der Solarzelle
- Fig. 4: Das Verfahren des Schrägaufdampfens unter verschiedenen Winkeln a) tan α < b/a, b) tan α = b/a und c) tan α > b/a auf strukturierte Oberflächen und die daraus erfindungsgemäß resultierenden elektrisch leitfähigen Kontakte
- Fig. 5: Ätzrale von Aluminium in Abhängigkeit vom Aufdampfwinkel α

Die erfindungsgemäßen Lehren sind grundsätzlich bei jeder Solarzelle realisierbar, werden jedoch nur für Zellen mit einem dotierten pn-Übergang beschrieben. Dabei werden - soweit möglich - für gleiche Elemente gleiche Bezugszeichen verwendet.

Fig. 1 zeigt in schematischer Darstellung einen Ausschnitt einer Solarzelle (1) mit zumindest einer Halbleiteroberfläche (2) auf der Kanten (3) ausgebildet sind , an die sich flankenartige Bereiche (4) anschließen und elektrisch leitfähige Kontakte (5) mittelbar oder unmittelbar auf zumindest einen Teil der flankenartigen Bereiche aufgebracht sind. Die Kanten und flankenartigen Bereiche lassen sich einfach mit Hilfe bewegter mechanischer Strukturierungselemente (z.B. diamantbesetzte Werkzeuge, Drähte mit Läppmittel) oder durch Verwendung von Laserschreibern zesbilden. Die Metallisierung kann durch das Verfahren des Vakuumaufdampfens unter einem kleinen Winkel zur Substratoberfläche erfolgen.

Die Herstellung der Solarzelle der in Fig. 1 gezeigten Solarzelle ist sehr einfach. Ein Beispiel für eine Prozeßfolge zur erfindungsgemäßen Herstellung einer pn-Solarzelle wird im Folgenden detailliert beschrieben. Dabei besteht der Prozeß prinzipiell aus den folgenden acht Prozeßschritten:
1. Ausbildung der flankenartigen Bereiche auf der Solarzellenoberfläche
2. Reinigung
3. Ausbildung des pn-Übergangs durch Diffusion von Fremdatomen
4. Aufbringen des Rückkontaktes und Sintern
5. Aufbringen des Vorderseitenkontaktes durch Schrägaufdampfen
6. Abätzen des überschüssigen Metalls von allen nicht flankenartigen Bereichen
7. Aufbringen eines Busbars
8. Aufbringen einer Antireflexschicht

Verfahrensmäßig wird dabei wie folgt vorgegangen: Nach der Ausbildung der parallel verlaufenden Kanten (3) und ihrer flankenartigen Bereiche (4) z. B. mittels einer diamantbesetzten Schleifscheibe wird von der Solarzellenoberfläche durch Abätzen eine dünne durch das Sägen geschädigte Obenlachenschicht abgetragen, da diese Schicht mit ihren Versetzungen und Verunreinigungen eine erhöhte Oberflächenrekombination und damit einen geringeren Wirkungsgrad zur Folge häne. Danach erfolgt üblicherweise eine naßchemische Reinigung, um alle organischen und metallischen Verunreinigungen von der Solarzellenoberflächezu entfernen. In einem nächsten Schritt wird die Solarzellenrückseite mit einer Diffusionsbarriere aus z.B. PECVD Siliziumnitrid versehen, um nur auf der Vorderseite durch Diffusion von geeigneten Fremdatomen (z.B. Phosphor bei p-dotiertem Substrat) einen pn-Übergang zu erzeugen. Nach der Diffusion wird die Diffusionsbarriere von der Rückseite durch Abätzen in Flußsäure entfernt. Anschließend wird der metallische Rückkontakt durch Aufdampfen oder Siebdruck aufgebracht und gesintert. Danach erfolgt die Ausbildung der Vorderseitenkontakte. Dies geschieht z.B. durch physikalisches Aufdampfen einer Metallschicht im Vakuum unter einem flachen Winkel zur Substratoberfläche sowie anschließendes naßchemisches maskierungsfreies und selektives Abätzen des überschüssigen Metalls von allen nicht flankenartisen Bereichen (6) in einer für das jeweilige Metall geeigneten und allgemein bekannten Ätzlösung (z.B. Ammoniaklösung, Salzsäure oder Aluminiumätze). Abschließend werden die einzelnen durch das Aufbringen einer elektrisch leitenden Querverbindung (Busbar) miteinander verbunden und die Solarzelle mit einer Antireflexbeschichtung z.B. aus PECVD Siliziumnitrid versehen.

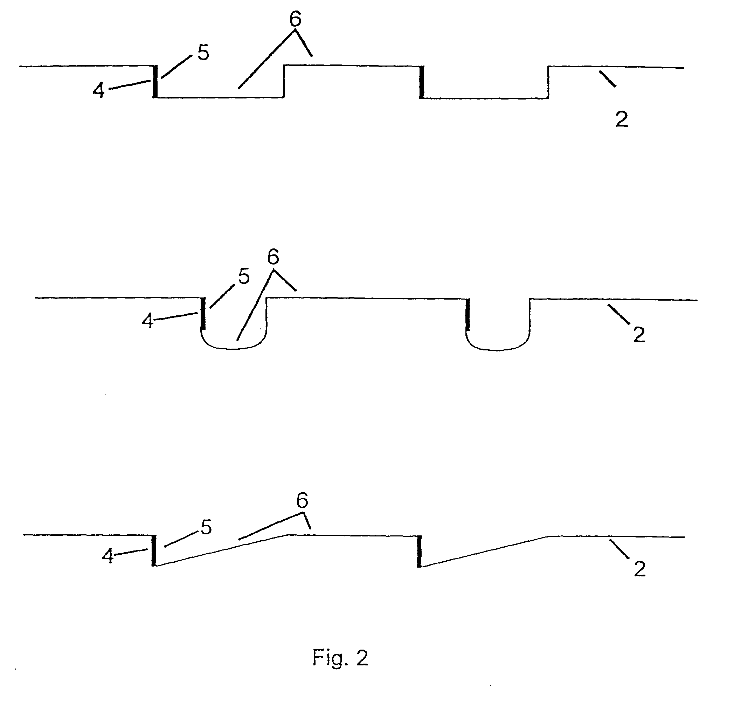

Zur Oberflächenstrukuturierung ist es möglich, alternativ zu diamantbesetzten Werkzeugen auch einen bewegten Draht unter Zugabe eines Läppmittels oder Laserstrahl zu verwenden. Dabei können die sich an die flankenartigen Bereiche anschließenden Gebiete je nach verwendetem Werkzeug z.B. kastenförmig, rinnenförmig oder dreiecksförmig ausgebildet sein (siehe Fig. 2). Erfindungsgemäß wichtig ist lediglich, daß ein parallel oder nahezu parallel zur Substratnormale verlaufender flankenartiger Bereich (4) ausreichender Breite ausgebildet wird. Üblicherweise liegt diese Breite je nach Fingerabstand zwischen 5 und 50 µm. Vorteilhaft sind hierbei Strukturen, die einen möglichst geringen Siliziumabtrag zur Ausbildung der flankenartigen Bereiche erfordern, da Strukturierungskosten in erster Näherung proportional sind zum zu entfernenden Siliziumvolumen. Soll neben der zur Kontaktherstellung notwendigen Struktur eine den Lichteinfang der Solarzelle verbessernde wesentlich feinere Struktur (8) (z.B. Pyramiden oder Rillen, siehe auch Fig. 3a) aufgebracht werden, so kann dies sowohl auf mechanische als auch auf chemische Weise nach der Herstellung der Grobstruktur zur Kontaktaufbringung geschehen.

Die in Fig. 3b gezeigte, u.a. der Verbesserung der Sammlung der Minoritätsladungsträger im Volumen des Halbleiters dienende Struktur (9) hat sägezahnförmige Gestalt, wobei die linke Flanke zusätzlich das auftreffende Licht in das Halbleitersubstrat (2) reflektiert. Die Verlegung des sammelnden pn-Übergangs in den Halbleiter kann sich von ca. 10 µm bis ca. 150 µm erstrecken. Diese Doppelfunktion der Struktur im Hinblick auf die optische und elektrische Situation ist besonders für chemisch nicht texturierbare Halbleitermaterialien geringer Diffusionslänge von Vorteil, wie z.B. multikristallines oder bandgezogenes Material. Auch andere Formen der Vertiefungen zur Erhöhung der Sammlungswahrscheinlichkeit von Minoritätsladungsträger (rechteckförmig, halkreisförmig, v-förmig, u.a.) sind denkbar.

Die Erzeugung des pn-Übergangs auf der Solarzellenvorderseite kann statt durch Diffusion aus der Gasphase auch durch Aufschleudern einer dotierstoffhaltigen Flüssigkeit (spin-on dopant) erfolgen. Auch kann das Aufbringen einer rückseitigen Diffusionsbarriere entfallen, wenn in einem nachfolgenden Prozeßschritt die eingebrachten Fremdatome auf der Rückseite durch eine entsprechende zweite Sorte von Fremdatomen kompensiert werden z.B. durch Erzeugung eines Aluminium Back-Surface-Fields. Die Erzeugung des pn-Übergangs (11) kann aber auch durch das Aufbringen fester Ladungen (Cs-Ionen und Siliziumnitrid) und einer daraus resultierenden Inversion der Halbleiteroberfläche erfolgen.

Erfindungsgemäß sollen zwei Möglichkeiten, die Breite k der elektrisch leitenden Kontakte (5) beim Aufbringen der Vorderseitenkontakte durch physikalisches Vakuumaufdampfen unter einem flachen Winkel zur Substratoberfiäche auf die flankenartigen Bereiche (4) festzulegen, hervorgehoben werden (siehe Fig. 4). Bei der ersten Möglichkeit wird die Kontaktbreite k durch den Aufdampfwinkel α und den Abstand a der Schattenwurfkante von dem zu bedampfenden flankenartigen Bereich bestimmt. Es gelten: tan α < b/a und k = a*tan α, wobei b die Breite des flankenartigen Bereiches angibt. Bei der zweiten Möglichkeit hingegen wird die Kontaktbreite k ausschließlich durch die Breite b des flankenartigen Bereichs bestimmt. Hierbei geken: tan α ≥ b/a und k = b. Diese Anwendung des erfindungsgemäßen Verfahrens erweist sich als sehr vorteilhaft, wenn im industriellen Produktionsmaßstab auf die genaue Einstellung des Aufdampfwinkels α verzichtet werden soll. Die Einstellung der Breite b der flankenartigen Bereiche ist wesentlich einfacher. Hinzu kommt, daß die Kontaktbreite k somit frei von den einschränkenden Bedingungen (geringer Abstand a und geringe Divergenz des Aufdampfstrahls) für einen scharfen Schattenwurf durch die Kanten der Oberflächenstruktur ist.

Eine weitere vorteilhafte Ausgestaltungsmöglichkeit der Erfindung beinhaltet die Halbleiteroberfläche (2) vor Aufbringung der Kontakte erst mit einer Passivierschicht (7) zu versehen, diese dann in schmalen Kontaktbereichen zu öffnen und dann mit breiteren Metallkontakten (5) zu versehen, die sowohl auf der geöffneten Halbleiteroberfläche als auch zumindest teilweise auf der Passivierschicht verlaufen (siehe Fig. 1 b). Hierdurch kann die mit einer hohen Ladungsträgerrekombination verbundene Metall-Halbleiter-Kontaktfläche drastisch vermindert werden. Dies hat eine vorteilhafte Erhöhung der Leerlaufspannung und somit des Wirkungsgrades zur Folge. Anders als in EP 0548863 beschrieben verläuft der elektrisch leitende Metallkontakt erfindungsgemäß nicht auf plateauartigen Bereichen, sondern ausschließlich auf den flankenartigen Bereichen (4), die parallel oder nahezu parallel zur Substratnormale verlaufen. Hieraus ergibt sich eine deutlich verminderte Abschattung durch die opaken Metallfinger und somit ein Wirkungsgradvorteil.

Auch kann das erfindungsgemäße Verfahren zur Herstellung der Rückseitenkontakte von Solarzellen angewandt werden. Hierbei wird verfahrensmäßig genauso vorgegangen wie bei der Herstellung der Vorderseitenkontakte. Vorzugsweise verlaufen die rückseitigen Metallkontakte senkrecht zu den vorderseitigen um mögliche Serienwiderstandsverluste zu minimieren. Der die Erfindung prägende Vorschlag, die Leiterbahnen selbstjustierend auf parallel oder nahezu parallel zur Substratnormalen verlaufenden flankenartigen Bereichen aufzubringen, ist auch für den Solarzellenrückkontakt aus mehreren Gründen vorteilhaft. Zum einen ermöglicht dieses Verfahren die einfache Herstellung beidseitig lichtempfindlicher Solarzellen, sogenannter Bifacial-Zellen, da nicht wie bei herkömmlichen Solarzellen die gesamte Rückseite mit Metall bedeckt wird. Zum anderen kommen für die Rückseite auch alle für die Vorderseite beschriebenen Vorteile voll zur Geltung.

Der Fig. 1 d ist noch einmal eine bevorzugte Ausführungsform der erfindungsgemäßen Solarzelle zu entnehmen. Dabei ist mit "b" die Höhe des flankenartigen Bereichs 4 gekennzeichnet. der senkrecht oder nahezu senkrecht zur von der Solarzellenoberfläche aufgespannten Ebene verläuft. Der sich an einen entsprechenden flankenartigen Bereich 4 von der Substratoberfläche ausgehend anschließende und in der Ebene der Substratoberfläche verlaufende clateauartige Abschnitt 20 weist eine Breite h auf. Von dem plateauartigen Bereich 20 geht die zum bodenseitigen Rand 22 des flankenartigen Bereichs 4 vertaufende Fläche 24 aus. Die durch den Übergang der Flächen 20, 22 gebildete Kante SK ist eine sogenannte Schattenwurfkante, die in Abhängigkeit von dem Aufdampfwinkel α vorgibt, über welche Höhe das elektrisch leitende Material auf dem flankenartigen Bereich 4 zur Ausbildung des elektrisch leitenden Kontaktes 5 abgeschieden wird. Die entsprechende Höhe ist mit k gekennzeichnet.

In Projektion auf die von der Oberfläche der Solarzelle aufgespannte Ebene beträgt die Breite des plateauartigen Bereichs 20 "h" und die der hierzu schräg verlaufenden Fläche 24 "a", wobei die Breite a der Fläche 24 größer als die Höhe b des flankenartigen Bereichs 4 ist, insbesondere a > 3 b.

Der Abstand zwischen aufeinanderfolgenden flankenartigen Bereichen 4, auf denen sich elektrisch leitende Kontakte 5 befinden, beträgt A, wobei insbesondere 100 µm < A < 2000 µm betragen sollte. Die Höhe b der flankenartigen Bereiche selbst beträgt vorzugsweise 5 µm < b < 200 µm.

Den Fig. 4 ist eine besonders hervorzuhebende Ausführungsform einer erfindungsgemäßen Solarzelle zu entnehmen, bei der die Vertiefungen einer kastenförmigen Geometrie folgen. So ist grundsätzlich jede Vertiefung durch zwei flankenartige Bereiche 4, 26 begrenzt, von denen einer mit dem elektrisch leitenden Material versehen ist und die jeweils senkrecht zu der von der Solarzellenoberfläche 30 aufgespannten Ebene verlaufen. Entsprechend sind die flankenartigen mit dem elektrisch leitenden Material versehenen Bereiche 4 der anderen Ausführungsbeispiele ebenfalls senkrecht zu der von der Halbleitermaterialoberfläche aufgespannten Ebene ausgerichtet.

Die eine gleiche oder im Wesentlichen eine gleiche Höhe aufweisenden ersten und zweiten Flanken 4, 26 sind über eine bodenseitige Fläche 28 der Vertiefung verbunden. Durch den Verlauf der Flanken 4, 26 und der Bodenfläche 28 ergibt sich die gewünschte kastenförmige Geometrie der Vertiefung.

## Patentansprüche

1. Solarzelle (1) umfassend ein Halbleitermaterial für ein Halbleitersubstrat, in welchem durch einfallende Strahlungsenergie Ladungsträger erzeugbar sind, die durch ein elektrisches Feld trennbar und sodann über auf dem Halbleitersubstrat vorhandene erste und zweite elektrisch leitende Kontakte (5) ableitbar sind, wobei auf ciner ersten Halbleitersubstratoberfläche (2) rinnenförmige Vertiefungen mit jeweils zumindest einem senkrecht oder nahezu senkrecht zur von der ersten Halbleiteroberfläche aufgespannten Ebene verlaufenden flankenartigen Bereich (4) vorhanden sind und wobei auf einem oder mehreren der flankenartigen Bereiche elektrisch leitfähiges Material zur Ausbildung des ersten elektrisch leitenden Kontaktes (5) aufgebracht ist, der sich ausschließlich auf den entsprechenden flankenartigen Bereich erstreckt,
**dadurch gekennzeichnet,**
**dass** zwischen aufeinanderfolgenden Vertiefungen ein in oder in etwa in der von der Halbleiteroberfläche aufgespannten Ebene verlaufender plateauartiger Bereich (20) und/oder eine parallel oder in etwa parallel zu der von der Halbleiteroberfläche aufgespannten Ebene verlaufende bodenseitige Fläche (28) verläuft.

2. Solarzelle nach Anspruch 1,
**dadurch gekennzeichnet,**
**dass** der plateauartige Bereich (20) in zum bodenseitigen Rand (22) des flankenartigen Bereichs (4) verlaufende Fläche (24) der Solarzelle (1) übergeht, wobei insbesondere die Fläche zum flankenartigen Bereich einen Winkel γ mit 60° ≤ γ ≤ 75° beschreibt.

3. Solarzelle nach Anspruch 1,
**dadurch gekennzeichnet,**
**dass** der plateauartige Bereich (20) in einen parallel zum ersten flankenartigen Bereich verlaufenden zweiten flankenartigen Bereich (26) übergeht, der mit dem ersten flankenartigen Bereich über eine bodenseitige Fläche (28) der Vertiefung verbunden ist, die insbesondere senkrecht zu den flankenartigen Bereichen verläuft.

4. Solarzelle nach zumindest einem der vorhergehenden Ansprüche,
**dadurch gekennzeichnet,**
**dass** der plateauartige Bereich 20 eine Breite h und die Fläche (24) in Projektion auf die von der Halbleiteroberfläche aufgespannte Ebene eine Breite a aufweisen, wobei h > 2µm, insbesondere 5000µm > h > 2µm ist und/oder der flankenartigc Bereich (4) eine Höhe b mit b < a, insbesondere a > 3b aufweist.

5. Solarzelle nach zumindest einem der vorhergehenden Ansprüche,
**dadurch gekennzeichnet,**
**dass** der elektrisch leitende Kontakt (5) entlang des flankenartigen Bereichs (4) über dessen gesamte oder nahezu gesamte Länge verläuft und insbesondere das elektrisch leitende Material zur Ausbildung des einen elektrisch leitenden Kontaktes (5) von der oberflächenseitigen Kante (3) ausgeht, wobei vorzugsweise sich der elektrisch leitende Kontakt über eine Höhe k erstreckt, die in etwa der Höhe b des flankenartigen Bereichs (4) entspricht.

6. Solarzelle nach zumindest einem der vorhergehenden Ansprüche,
**dadurch gekennzeichnet,**
**dass** der flankenartige Bereich (4) bodenseitig in einen parallel oder in etwa parallel zu der von der Halbleiteroberfläche aufgespannten Ebene verlaufenden ersten Bodenabschnitt 10 übergeht, der seinerseits in einen zweiten eine Senke bildenden Bodenabschnitt übergeht, der von einem zweiten flankenartigen Bereich 26 der Vertiefung begrenzt ist, wobei insbesondere die im Schnitt V- oder dreieck-förmig ausgebildete Senke eine Tiefe T aufweist, die zumindest in etwa gleich der Höhe b des ersten flankenartigen Bereichs (4) ist.

7. Solarzelle nach zumindest einem der vorhergehenden Ansprüche,
**dadurch gekennzeichnet,**
**dass** die rinnenförmigen Vertiefungen im Schnitt eine U-, Kreisabschnitt- oder Dreieckform aufweisen und dass insbesondere die Halbleiteroberfläche im Bereich des flankenartigen Bereichs auf der Oberfläche außerhalb der vorzugsweise eine kastenförmige Geometrie aufweisenden Vertiefungen und/oder innerhalb der Vertiefungen durch z.B. Pyramiden, Gräben oder Rillen gebildete Strukturen (8) aufweisen, wobei vorzugsweise die Strukturen im Vergleich zur Höhe b des flankenartigen Bereichs (4) klein sind.

8. Solarzelle nach zumindest einem der vorhergehenden Ansprüche,
**dadurch gekennzeichnet,**
**dass** die Solarzelle vorder- und/oder rückseitig die mit dem elektrisch leitenden Material verschenen flankenartigen Bereiche (4) aufweist.

9. Solarielle nach zumindest einem der vorhergehenden Ansprüche,
**dadurch gekennzeichnet,**
**dass** aufeinanderfolgende parallel oder nahezu parallel zueinander verlaufende mit dem elektrisch leitenden Material versehene flankenartige Bereiche (4) einen Abstand A mit 30µm < A < 5000µm, insbesondere 100µm < A < 2000µm aufweisen und/oder dass die Höhe b des flankenartigen Bereichs (4) 5µm < b < 200µm beträgt.

10. Solarzelle nach zumindest einem der vorhergehenden Ansprüche,
**dadurch gekennzeichnet,**
**dass** zwischen dem elektrisch leitfähigen Material und dem flankenartigen Bereich (4) bereichsweise eine Passivierschicht (7) verläuft.

11. Solarzelle nach zumindest einem der vorhergehenden Ansprüche,
**dadurch gekennzeichnet,**
**dass** die die flankenartigen Bereiche (4) aufweisenden Vertiefungen auf der Halbleiteroberfläche durch Abscheiden von Halbleitermaterial auf einem entsprechende Strukturen aufweisenden Substrat ausgebildet sind.

12. Verfahren zur Herstellung einer Solarzelle nach einem der Ansprüche 1-11 umfassend ein Halbleitermaterial für ein Halbleitersubstrat, in welchem durch einfallende Strahlungsenergie Ladungsträger crzeugbar sind, die durch ein elektrisches Feld trennbar und sodann über auf dem Halbleitersubstrat vorhandene erste und zweite elektrisch leitende Kontakte ableitbar sind, wobei auf einer ersten Halbleitersubstratoberfläche rinnenförmige Vertiefungen mit ersten flankenartigen Bereichen ausgebildet werden, auf denen ausschließlich elektrisch leitfähiges Material zur Ausbildung der ersten elektrisch leitenden Kontakte aufgebracht wird,
**dadurch gekennzeichnet,**
**dass** die flankenartigen Bereiche derart ausgebildet werden, dass diese senkrecht oder nahezu senkrecht zur von der ersten Halbleitersubstratoberfläche aufgespannten Ebene verlaufen, dass das elektrisch leitende Material zur Ausbildung der ersten elektrisch- leitenden Kontakte maskierungsfrei und selektiv von den Bereichen der Halbleiteroberfläche durch Ätzen abgetragen wird, die außerhalb des flankenartigen Bereichs verlaufen.

13. Verfahren nach Anspruch 12,
**dadurch gekennzeichnet,**
**dass** das elektrisch leitfähige Material durch physikalisches Aufdampfen (PVD) im Vakuum unter einem Winkel α zur von der Substratoberfläche aufgespannten Ebene mit 90° > α > 0°, vorzugsweise 30° > α > 1° aufgebracht wird.

14. Verfahren nach Anspruch 12 oder 13,
**dadurch gekennzeichnet,**
**dass** das elektrisch leitfähige Material zur Ausbildung eines Metall-Isolator-Kontaktes (MIS-Kontakt) auf einer auf der Halbleiteroberfläche befindliche Tunnelisolatorschicht aufgebracht wird, dass die Halbleiteroberfläche zur Ausbildung der die flankenartigen Bereiche aufweisenden Vertiefungen durch bewegte mechanische Strukturierungselemente, durch Laserstrahlen oder durch Ätztechniken behandelt wird.

## Claims

1. A solar cell (1) comprising a semiconducting material for a semiconducting substrate, in which incident radiation energy can generate charge carriers separatable by an electric field and then conductible by first and second electrically conductive contacts (5) being present on the semiconducting substrate, where on a first surface of the semiconducting substrate (2) groove-like depressions are present, with at least one flank-like region (4) running perpendicular or nearly perpendicular to the plane defined by said first surface of the semiconducting material and where on one or more of the flank-like regions electrical conductive material is applied for formation of said first electrically conducting contact (5) extending on said flank-like region only,
**characterized in**
**that** a plateau-like region (20) and/or a bottom-side surface (28) extend between successive depressions, said plateau-like region (20) and said bottom-side surface (28) running in parallel or nearly in parallel in the plane defined by the semiconductor surface.

2. A solar cell according to claim 1,
**characterized in**
**that** the plateau-like region (20) merges into an area (24) of the solar cell (1), said area (24) running to the bottom-side edge (22) of said flank-like region (4), where particularly the area extending to said flank-like region is having an angle γ of 60° ≤ γ ≤ 75°.

3. A solar cell according to claim 1,
**characterized in**
**that** the plateau region (20) merges into a second flank-like region (26) running in parallel to the first flank-like region, said second flank-like region being connected to the first flank-like region via a bottom-side surface (28) of the depression running particularly perpendicular to the flank-like regions.

4. A solar cell according to at least one of the preceding claims,
**characterized in**
**that** said plateau-like region (22) has a width h and the area (24) in projection onto the plane defined by the semiconductor surface has a width a, wherein h > 2 µm, particularly 5000 µm > h > 2 µm, and/or said flank-like region (4) has a height b with b < a, and particularly a > 3b.

5. A solar cell according to at least one of the preceding claims,
**characterized in**
**that** said electrically conducting contact (5) extends on the entire length or nearly entire length of said flank-like region (4) and in particular the electrically conducting material for the formation of the one electric conductive contact (5) originates from said top surface-side edge (3), wherein preferably said electrically conducting contact spans over a height k, which is about the same as the height b of said flank-like region (4).

6. A solar cell according to at least one of the preceding claims,
**characterized in**
**that** said flank-like region (4) merges into a first bottom section (26) running in parallel or nearly in parallel to the plane defined by the semiconductor surface, said first bottom section in turn merges into a second groove forming bottom section (28), which is restricted from a second flank-like region (30) of the depression, wherein particularly said groove being designed v-like or triangular in cross section has a depth T, which at least has about the same height b as the first flank-like region (4).

7. A solar cell according to at least one of the preceding claims,
**characterized in**
**that** said groove-like depressions have a U-, circle segment or triangular shaped cross section and that particularly the semiconductor surface in the region of said flank-like region on the surface outside the depression preferably having a square geometry and/or inside the depression shows structures (8) formed by, e.g., pyramids, grooves or slots, wherein said structures preferably are small compared to the height b of said flank-like region (4).

8. A solar cell according to at least one of the proceeding claims,
**characterized in**
**that** said solar cell on its front and/or back shows said flank-like areas (4) provided with the electrical conductive material.

9. A solar cell according to at least one of the preceding claims,
**characterized in**
**that** successive parallel or nearly parallel running flank-like regions (4) being provided with the electrical conductive material have a distance A of 30 µm < A < 5000 µm, particularly 100 µm < A < 2000 µm, and/or that the height b of said flank-like region (4) amounts to 5 µm < b < 200 µm.

10. A solar cell according to at least one of the preceding claims,
**characterized in**
**that** between the electrical conductive material and the flank-like region (4) a passivation layer (7) extends partially.

11. A solar cell according to at least one of the preceding claims,
**characterized in**
**that** said depressions having the flank-like regions (4) are formed on the semiconductor surface by deposition of semiconductor material onto a substrate having a corresponding structures.

12. A method for fabrication of a solar cell according to one of the claims 1 to 11, comprising a semiconductor material for a semiconductor substrate, in which incident radiation energy can generate charge carriers separatable by an electric field and conductible by first and second electrically conductive contacts being present on the semiconducting substrate, where on a first surface of the semiconducting substrate groove-like depressions having first flank-like regions are formed, onto which exclusively electrical conductive material is applied in order to form the first electrical conductive contact,
**characterized in**
said flank-like regions are formed in such a way that they run perpendicular or nearly perpendicular to the plane defined by the semiconductor substrate surface, that the electrical conductive material is removed by mask-free and selective etching from the regions of the semiconductor surface, which are running outside of said flank-like regions, in order to form the first electrical conductive contacts.

13. The method according to claim 12,
**characterized in**
**that** said electrical conductive material is applied by means of physical vacuum evaporation (PVE) with an angle α to the plane defined by the substrate surface with 90° > α > 0°, preferably 30° > α > 1 °.

14. The method according to claim 12 or 13,
**characterized in**
**that** said electrical conductive material for the formation of a metal-insulator-contact (MIS-contact) is applied to a tunnel insulator layer located on the semiconductor surface , that the semiconductor surface for the formation of the depressions having said flank-like regions is treated by agitated mechanical structuring elements, by laser beams or by etching techniques.

## Revendications

1. Cellule solaire (1) comprenant un matériau semi-conducteur pour un substrat semi-conducteur, dans lequel peuvent être générés par une énergie rayonnée incidente des supports de charge qui peuvent être séparés par un champ électrique et ensuite dérivés par des premier et second contacts électro-conducteurs (5) présents sur le substrat semi-conducteur, avec sur une première surface de substrat semi-conducteur (2) des creux en forme de rainures ayant chacun au moins une zone en forme de rebord (4) courant perpendiculairement ou presque perpendiculairement au plan défini par la première surface de semi-conducteur, alors que sur une ou plusieurs des zones en forme de rebord on applique un matériau électro-conducteur pour former le premier contact électro-conducteur (5), qui s'étend exclusivement sur la zone en forme de rebord correspondante,
**caractérisée en ce que**
entre des creux voisins court une zone en forme de plateau (20) courant dans ou sensiblement dans le plan défini par la surface de semi-conducteur et/ou une surface de fond (28) courant parallèlement ou sensiblement parallèlement au plan défini par la surface de semi-conducteur.

2. Cellule solaire selon la revendication 1
**caractérisée en ce que**
la zone en forme de plateau (20) se poursuit dans une surface (24) de la cellule solaire (1) courant jusqu'au bord du côté du fond (22) de la zone en forme de rebord (4), et en particulier la surface décrit par rapport à la zone de rebord un angle γ tel que 60° ≤ γ ≤ 75°.

3. Cellule solaire selon la revendication 1
**caractérisée en ce que**
la zone en forme de plateau (20) se poursuit dans une deuxième surface de rebord (26) courant parallèlement à la première zone de rebord, et qui est reliée à la première zone de rebord par une surface de fond (28) qui court perpendiculairement aux zones de rebord.

4. Cellule solaire selon au moins une des revendications précédentes
**caractérisée en ce que**
la zone en forme de plateau (22) présente une largeur h et la surface (24) en projection sur le plan défini par la surface de semi-conducteur une largeur a, avec h > 2 µm, en particulier 5000 µm > h > 2 µm, et/ou la zone en forme de rebord (4) présente une hauteur b avec b < a, en particulier a > 3 b.

5. Cellule solaire selon au moins une des revendications précédentes
**caractérisée en ce que**
le contact électro-conducteur (5) court le long de la zone en forme de rebord (4) sur toute ou presque toute sa longueur et en particulier le matériau électro-conducteur formant le contact électro-conducteur (5) part du bord du côté de la surface (3), le contact électro-conducteur s'étendant de préférence sur une hauteur k qui correspond environ à la hauteur b de la zone en forme de rebord (4).

6. Cellule solaire selon au moins une des revendications précédentes
**caractérisée en ce que**
la zone en forme de rebord (4) se poursuit du côté du fond dans une première section de fond (10) parallèle ou sensiblement parallèle au plan défini par la surface de semi-conducteur, qui se poursuit de son côté dans une deuxième section de fond formant une pente limitée par une deuxième zone en forme de rebord (26) du creux, la pente formée en coupe en forme de V ou de triangle présentant une profondeur T qui est au moins sensiblement égale à la hauteur b de la première zone en forme de rebord (4).

7. Cellule solaire selon au moins une des revendications précédentes
**caractérisée en ce que**
les creux en forme de rainures présentent en coupe une forme de U, de segment de courbe ou de triangle et qu'en particulier la surface de semi-conducteur dans la région de la zone en forme de rebord sur la surface, à l'extérieur des creux présentant de préférence une géométrie en forme de caisson et/ou à l'intérieur des creux, présente des structures (8) formées par exemple par des pyramides, des tranchées ou des cannelures, les structures étant de préférence petites par rapport à la hauteur b de la zone en forme de rebord (4).

8. Cellule solaire selon au moins une des revendications précédentes
**caractérisée en ce que**
la cellule solaire présente sur les faces avant et/ou arrière les zones en forme de rebord (4) dotées du matériau électro-conducteur.

9. Cellule solaire selon au moins une des revendications précédentes
**caractérisée en ce que**
des zones en forme de rebord (4) successives courant parallèlement ou presque parallèlement entre elles, dotées du matériau électro-conducteur, présentent une distance A avec 30 µm < A < 5000 µm, en particulier 100 µm < A < 2000 µm, et/ou la hauteur b de la zone en forme de rebord (4) est telle que 5 µm < b < 200 µm.

10. Cellule solaire selon au moins une des revendications précédentes
**caractérisée en ce que**
entre le matériau électro-conducteur et la zone en forme de rebord (4) court sur une zone une couche de passivation (7).

11. Cellule solaire selon au moins une des revendications précédentes
**caractérisée en ce que**
les creux présentant des zones en forme de rebord (4) sont formés sur la surface de semi-conducteur par le dépôt de matériau semi-conducteur sur un substrat présentant des structures correspondantes.

12. Procédé de fabrication d'une cellule solaire selon une des revendications 1 à 11, comprenant un matériau semi-conducteur pour un substrat semi-conducteur, dans lequel peuvent être générés par une énergie rayonnée incidente des supports de charge qui peuvent être séparés par un champ électrique et ensuite dérivés par des premier et second contacts électro-conducteurs présents sur le substrat semi-conducteur, avec sur une première surface de substrat semi-conducteur des creux en forme de rainures avec des premières zones en forme de rebord, sur lesquelles exclusivement un matériau électro-conducteur est appliqué pour former les premiers contacts électro-conducteurs,
**caractérisé en ce que**
les zones en forme de rebord sont formées de telle sorte qu'elles courent perpendiculairement ou presque perpendiculairement au plan défini par la première surface de substrat électro-conducteur, le matériau électro-conducteur pour former les premiers contacts électro-conducteurs est enlevé sans masque et de manière sélective par gravure des zones de la surface de semi-conducteur qui courent à l'extérieur de la zone en forme de rebord.

13. Procédé selon la revendication 12,
**caractérisé en ce que**
le matériau électro-conducteur est déposé par dépôt physique en phase vapeur (PVD) sous vide sous un angle α par rapport au plan défini par la surface de substrat avec 90° > α > 0°, de préférence 30° > α > 1°.

14. Procédé selon la revendication 12 ou 13,
**caractérisé en ce que**
le matériau électro-conducteur pour former un contact métal-isolant (contact MIS) est appliqué sur une couche d'isolant tunnel se trouvant sur la surface de semi-conducteur, la surface de semi-conducteur pour former les creux présentant les zones en forme de rebord est traitée par des éléments de structuration mécaniques mobiles, par des rayons laser ou par des techniques de gravure.
